# EUROPEAN PATENT APPLICATION

(11) **EP 4 202 517 A1**
(43) Date of publication of application: **28.06.2023**
(21) Application number: 22207125.0
(22) Date of filing: 14.11.2022
(51) Int. Cl.: G02B 6/42

(54) **THERMAL CONTROL FOR CHIP TO CHIP OPTICAL COUPLING**

(30) Priority: 23.12.2021 US 202117561648
(71) Applicant: INTEL Corporation, Santa Clara, CA 95054 (US)
(72) Inventor: MENUMEROV, Eredzhep, San Jose, 95134 (US); CHENG, Lu, San Jose, 95126 (US); XIE, Boping, San Ramon, 94582 (US)
(74) Representative: Goddar, Heinz J.

(57) **Abstract**

A semiconductor photonic package can include a laser module and a photonic integrated circuit (PIC), each having a different operating temperature. The two modules are placed on a common substrate allowing accurate optical alignment. In addition, a thermal barrier is integrated into the substrate between the laser module and the PIC to provide thermal stability, especially to the laser module. The substrate can include a housing with good electrical conductivity or an optical substrate and housing. The thermal barrier is integrated into the optical substrate, the housing, or both. The thermal barrier in the optical substrate can be a cutout that does not divide the optical substrate into two separate pieces.

## Description

### FIELD

Descriptions are generally related to silicon packaging, and more particularly, descriptions are related to semiconductor photonic package.

### BACKGROUND

Some silicon photonic products have transmitter and receiver modules in one integrated circuit (IC) package. For example, the transmitter module can be a laser chip, and the receiver module can be a photonic integrated circuit (PIC). The laser chip and PIC must have an accurate and stable optical alignment to operate correctly. Placing the laser chip and PIC on a common substrate can provide an accurate and stable optical alignment.

The laser chip and the PIC often have different operating temperatures and tolerance requirements. For example, the module that generates the laser is susceptible to thermal fluctuation, and the laser frequency can change when the operating temperature of the laser chip varies. If the laser chip and PIC are mounted on a common substrate, the substrate region under the laser and PIC have different temperatures. The temperature difference between two substrate regions causes the heat to travel from the warmer to the colder region, known as thermal crosstalk.

Some implementations use thermoelectric coolers (TEC) under the substrate where the laser chip or the PIC are mounted or under both regions. Although using TEC reduces the thermal fluctuation, it does not address it completely.

Some implementations use two separate substrates, one for the laser chip and one for PIC. Separating the laser and PIC substrates provides thermal isolation. However, the optical alignment of the laser chip and PIC is very challenging and complicated. In addition, the placement tolerance and tolerance of bond line thickness under both components compromise the translational and rotational accuracies. In addition, using two separate substrates reduces the coupling efficiency and yield of assembled components.

### BRIEF DESCRIPTION OF THE DRAWINGS

The following description includes discussion of figures having illustrations given by way of example of an implementation. The drawings should be understood by way of example, and not by way of limitation. As used herein, references to one or more examples are to be understood as describing a particular feature, structure, or characteristic included in at least one implementation of the invention. Phrases such as "in one example" or "in an alternative example" appearing herein provide examples of implementations of the invention and do not necessarily all refer to the same implementation. However, they are also not necessarily mutually exclusive.
**Figure 1** is a block diagram of an example of a semiconductor photonic package.
**Figure 2A** is a block diagram of an example of a top view of a semiconductor photonic package.
**Figure 2B** is a block diagram of an example of a multiview projection of an optical substrate in a semiconductor photonic package.
**Figure 2C** is a block diagram of an example of a multiview projection of a housing in a semiconductor photonic package.
**Figure 2D-E** are block diagrams of examples of alternative geometric shapes of thermal barriers integrated in a substrate of a semiconductor photonic package.
**Figure 3A-C** are block diagrams of examples of thermal barriers integrated in a substrate of a semiconductor photonic package.
**Figure 4A-B** are block diagrams of examples of thermal barriers integrated in a housing of a semiconductor photonic package.
**Figure 5** illustrates simulated thermal diagrams of the top view of an optical substrate with and without a thermal barrier.
**Figure 6** is a flow diagram of a thermal barrier integration flow.
**Figure 7** is a block diagram of an example of a computing system that can include a photonic chip with an integrated thermal barrier.

Descriptions of certain details and implementations follow, including non-limiting descriptions of the figures, which may depict some or all examples, and well as other potential implementations.

### DETAILED DESCRIPTION

As described herein, a semiconductor photonic package can include two optically coupled modules. One example of a semiconductor photonic package includes a laser module optically coupled with a photonic integrated circuit (PIC). The two modules are mounted on a common substrate, allowing for accurate optical alignment and high-efficiency optical coupling. However, the two modules have different power levels and different operating temperatures. For example, the laser module has a different operating temperature than the PIC and is often more sensitive to temperature variation. Different operating temperatures and power levels traditionally cause thermal crosstalk in the substrate, which transfers heat from a warmer to a colder region. In one example, a thermal barrier is integrated into the substrate between the two modules to provide thermal isolation between the two modules, resulting in improved thermal stability.

In one example, providing a thermal barrier includes removing part of the substrate between the two optical modules. In one example implementation, a cutout in the substrate creates the thermal barrier. In another example, making one or more holes in the substrate forms a thermal barrier between the cold and warm regions of the substrate. One example can create a vacuum in the cutout region to provide thermal isolation. In another example, air fills the cutout regions. In an alternative example, materials with desired thermal and electrical characteristics fill the cutout's gap, cavity, or holes.

In one example, a laser chip and a PIC are coupled together via free-space optics in light detection and ranging (lidar) products. Optical alignment and coupling efficiency can be improved when the two components sit on a shared (or common) surface, which can be referred to as a shared substrate or optical bench. A thermal barrier integrated into the shared substrate would allow the laser chip and PIC to have accurate optical alignment and efficient optical coupling while also providing thermal stability.

In one example, the substrate in the semiconductor photonic package includes an optical substrate disposed on a housing. The optical substrate hosts the optical modules such as a laser chip and PIC. In one example, the optical substrate has low electrical conductivity and high thermal conductivity to dissipate heat. The housing has high electrical conductivity, and the optical substrate is attached to or mounted on the housing. In one example, the optical substrate is made of ceramic materials. Some ceramic substrates have high thermal conductivity and mechanical integrity that provide a robust platform for accurate optical alignment and efficient optical coupling. In one example, a material with a low thermal expansion coefficient is used to make optical substrates. An aluminum nitride (AIN) ceramic substrate is one example of ceramic substrates with high thermal conductivity and mechanical integrity. The AIN substrates are easy to manufacture. Moreover, using laser drilling or sandblasting techniques, thermal barriers, such as cutouts or holes, are easy to make in an AIN ceramic substrate.

In semiconductor photonic packaging with at least two photonic chips having different operating temperatures, creating a thermal barrier in the substrate allows photonic chips to share a common substrate while operating at two different temperatures. The thermal barrier provides temperature stability for the chips, and the common substrate provides mechanical integrity and stability for accurate optical alignment and high-efficiency optical coupling.

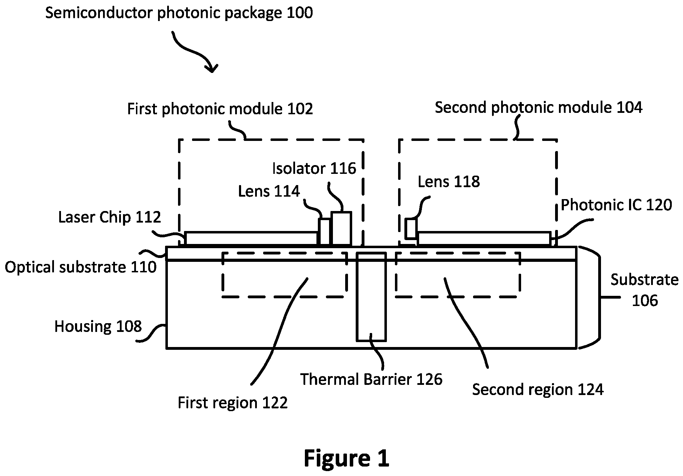

**Figure 1** is a block diagram of an example of a semiconductor photonic package. Semiconductor photonic package 100 includes first photonic module 102 and second photonic module 104. A module includes electrical, mechanical, or electro-mechanical components or their combinations. For example, an electrical component can be an integrated circuit, a field-programmable gate array (FPGA), or a controller. A mechanical component can include a lens, an isolator, or an optical filter. Examples of an electro-mechanical component can include a piezoelectrical material, a servo motor, or a nano opto-electro-mechanical system. At least an optical link optically couples photonic modules 102 and 104.

In one example, first photonic module 102 can generate a laser, modulate information on the laser, and send the laser signal to second photonic module 104. Second photonic module 104 receives the laser and extracts and uses the transmitted information. In another example, first photonic module 102 can generate a laser and send it to second photonic module 104. Second photonic module 104 would perform communication processing such as coding and modulation on the laser.

First photonic module 102 and second photonic module 104 are mounted on substrate 106. Substrate 106 provides a mechanical structure for photonic modules 102 and 104, a medium to dissipate heat from photonic modules 102 and 104, and electrical support for photonic modules 102 and 104 when needed.

The substrate's mechanical integrity and robustness are essential in the optical alignment of photonic modules 102 and 104-better optical alignment between photonic modules 102 and 104 results in higher optical coupling. A better alignment can be achieved when the photonic modules are mounted on a common substrate. The substrate on which the photonic modules are mounted is also referred to as an optical bench.

In one example, substrate 106 is made of material with high thermal conductivity to dissipate the heat efficiently. For example, boron arsenide (BAs) or aluminum nitride (AIN) have high thermal conductivity. Graphene is also used in semiconductor devices for its thermal and electrical properties.

In one example, photonic modules 102 and 104 generate heat when operational, and substrate 106 receives part of the generated heat. Therefore, first region 122 of substrate 106 under first photonic module 102 receives heat from first photonic module 102. Similarly, second region 124 of substrate 106 under the second photonic module 104 receives heat from second photonic module 104.

In one example, the operating temperature of first photonic module 102 is less than the operating temperature of second photonic module 104. Therefore, first region 122 is cooler than the second region 124, and a thermal crosstalk exists between two regions 122 and 124.

For example, in lidar devices, first photonic module 102 has an operating temperature and power different from second photonic module 104. As a result, first region 122 of substrate 106 has a different temperature than second region 124 of substrate 106. In most materials, when one region has a different temperature than another region, there will be a thermal crosstalk between the two regions. Thermal crosstalk causes the heat to travel from the warmer region towards the cooler region, which causes the temperature in the cooler region to increase. Consequently, thermal crosstalk can cause a variation in the operating temperature of the photonic modules 102 and 104.

In one example, first photonic module 102 needs to operate at a stable and non-varying operating temperature less than second photonic module 104. In one example, thermal variation can impact the performance of an optical module. For example, the wavelength of a laser can vary when the temperature of the module that generates the laser changes. Therefore, to generate a laser with a non-varying wavelength, the laser generating module needs to operate at a stable operating temperature. In one example, to reduce the thermal crosstalk that causes thermal fluctuation at the first photonic module 102, a thermal barrier 126 is integrated in the substrate 106. Thermal barrier 126 thermally separates first and second regions 122 and 124.

In one example, thermal barrier 126 is integrated in substrate 106 between first and second photonic modules 102 and 104. In one example, the thermal barrier 126 disrupts the thermal crosstalk between the substrate's first and second regions 122 and 124.

In one example, first photonic module 102 is a laser module. In one example, the laser module includes laser chip 112, lens 114, and isolator 116. The laser chip generates the optical beam or laser. The laser chip can also include communication hardware, software, or a combination of hardware and software. For example, the laser chip can generate a laser using semiconductor photonics combined with optical microresonators. Lens 114 concentrates the optical beams generated by the laser chip into non-divergent parallel beams. Isolator 116 protects the laser chip from any back reflection. In one example, lens 114 is directly attached to the photonic integrated circuit (IC) 120 and is not on substrate 106.

In one example, second photonic module 104 is a photonic integrated circuit (PIC) module. The PIC module includes lens 118 and photonic IC (PIC) 120. Lens 118 receives the laser light and couples it to PIC 120. PIC 120 includes components that operate on the laser. For example, PIC 120 can include optical components to perform arrayed waveguide grating (AWG), wavelength division multiplexing (WDM), or linear optical quantum computing operations.

In one example, substrate 106 includes optical substrate 110 and housing 108. First and second photonic modules 102 and 104 are mounted on the optical substrate 110, and substrate 110 is mounted on the housing 108. In one example, optical substrate 110 is made of materials with high thermal conductivity, including Aluminum Nitride (AIN).

In one example, substrate 106 includes housing 108. First and second photonic modules 102 and 104 are mounted on housing 108. In one example, housing 108 is made of materials with high electrical conductivity. In one example, housing 108 can include through-silicon vias (TSVs), electrical traces, heat sinks, and wire bondings, among other things.

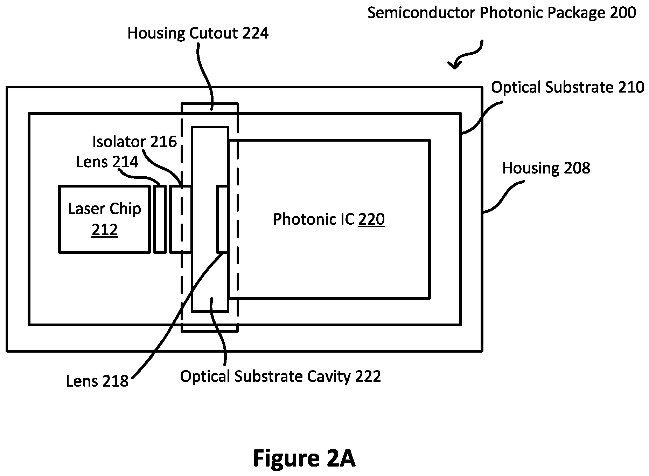

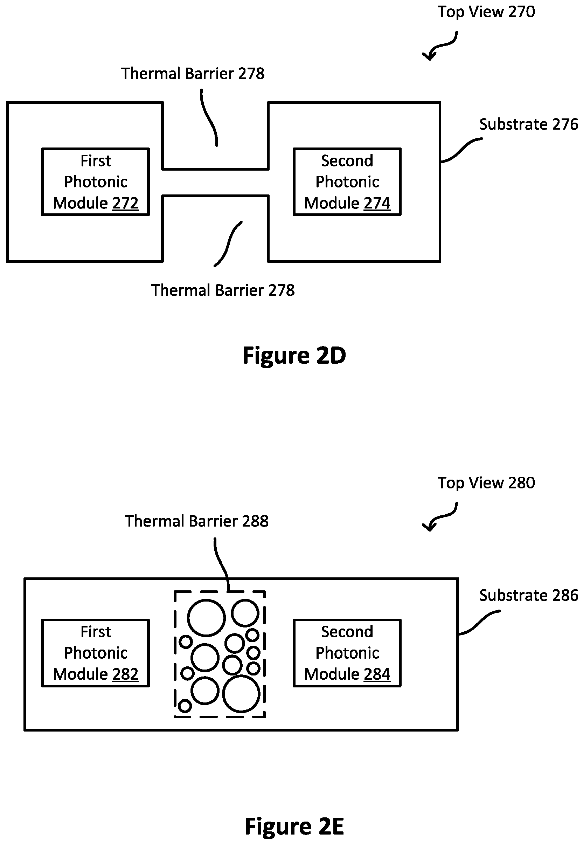

**Figure 2A** is a block diagram of an example of a top view of semiconductor photonic package 200. In one example, the first photonic module (for example, first photonic module 102 in Figure 1) is a laser module that includes laser chip 212, lens 214, and isolator 216, which is mounted on the optical substrate 210. In another example, the second photonic module (second photonic module 104 in Figure 1) is a PIC module that includes lens 218 and photonic IC 220, mounted on optical substrate 210. In one example, optical substrate 210 is mounted on housing 208.

In one example, the thermal barrier includes optical substrate cavity 222. In one example, optical substrate cavity 222 includes at least one hole or a cutout portion of the optical substrate 210.

In one example, the thermal barrier includes housing cutout 224. The dashed line defining the boundaries of the housing cutout 224 indicates the portion of the housing cutout 224 covered by optical substrate 210. While housing cutout 224 is illustrated as having a different size relative to optical substrate cavity 222, in one example, the opening in housing 208 has a surface footprint (the shape and size as seen from the perspective in Figure 2A) that is the same size as the opening in optical substrate 210. In one example, housing cutout 224 has a larger footprint than optical substrate cavity 222. In one example, housing cutout 224 and optical substrate cavity 222 have the same footprint. In one example, housing cutout 224 has a smaller footprint than optical substrate cavity 222.

In one example, the thermal barrier includes optical substrate cavity 222 and housing cutout 224. In one example, the thermal barrier is located between the first photonic module -laser chip 212, lens 214, and isolator 216- and the second photonic module -lens 218 and optical photonic IC 220.

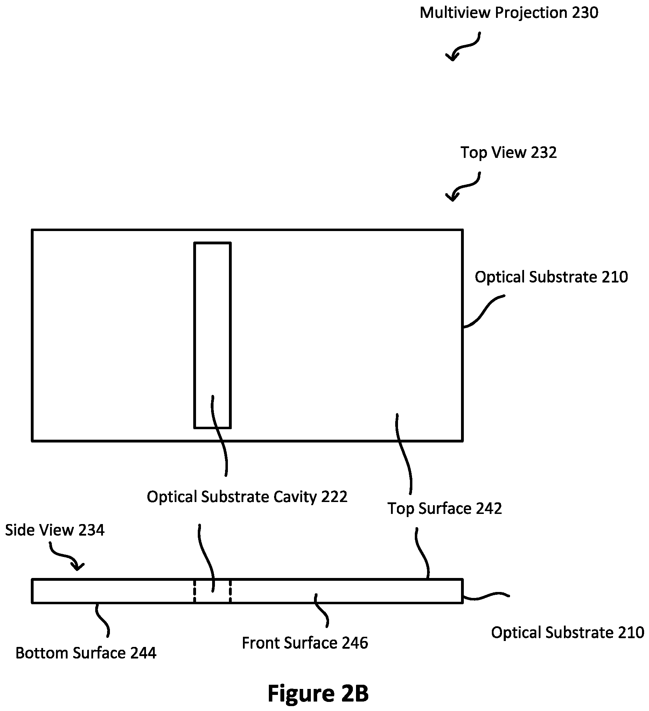

**Figure 2B** is a block diagram of an example of multiview projection 230 of optical substrate 210 in a semiconductor photonic package. Top view 232 shows the footprint of optical substrate 210 and optical substrate cavity 222.

In one example, top view 232 (or footprint) of optical substrate cavity 222 has a rectangular shape. In one example, top view 232 (or footprint) of optical substrate cavity 222 has rounded corners. The rounded corners can be fully rounded, resulting in a semicircle at each end of optical substrate cavity 222. In another example, the footprint of the optical substrate cavity 222 is contained within the boundaries of optical substrate 210 and does not divide optical substrate 210 into disjoint parts.

Side view 234 represents a cross-section of optical substrate 210 and shows the location of optical substrate cavity 222 in optical substrate 210. In one example, the dashed line of optical substrate cavity 222, illustrated in side view 234, indicates that optical substrate cavity 222 does not reach the front surface 246 of optical substrate 210. In one example, the dashed line of optical substrate cavity 222 extends from top surface 242 to bottom surface 244, indicating that optical substrate cavity 222 carves through optical substrate cavity 222 from top surface 242 to bottom surface 244.

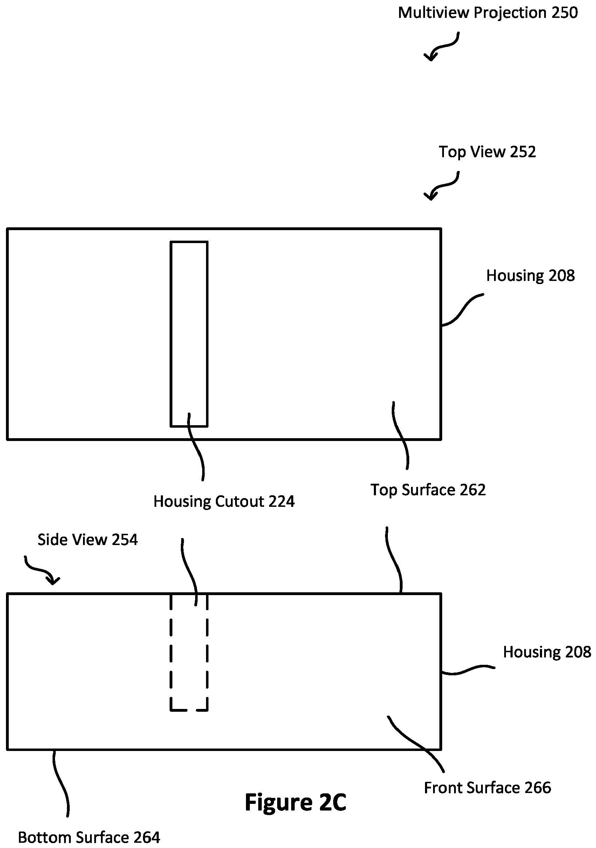

**Figure 2C** is a block diagram of an example of a multiview projection 250 of housing 208 in a semiconductor photonic package. Top view 252 shows the footprint of housing 208 and housing cutout 224.

In one example, top view 252 (or footprint) of housing cutout 224 has a rectangular shape. In one example, top view 252 (or footprint) of housing cutout 224 has rounded corners. The rounded corners can be fully rounded, resulting in a semicircle at each end of housing cutout 224. In another example, the housing cutout 224 is within the boundaries of housing 208 and does not divide housing 208 into disjoint parts.

Side view 254 represents a cross-section of housing 208 and shows the location of housing cutout 224 in housing 208. In one example, the dashed line at the boundaries of housing cutout 224, illustrated in side view 254, indicates that housing cutout 224 does not reach the front surface 266 of housing 208. In one example, the dashed line of housing cutout 224 extends from top surface 262 to bottom surface 264, indicating that housing cutout 224 carves through housing 208 from top surface 262 to bottom surface 264. In one example, as illustrated, the dashed line of housing cutout 224 extends from top surface 262 toward bottom surface 264 but does not extend all the way to bottom surface 264. The depth of housing cutout 224 can vary for different implementations, based on the photonic modules, the footprint of the cutout, the materials, or other factors.

In one example, the thermal barrier (e.g., thermal barrier 126 in Figure 1) includes optical substrate cavity 222 made in optical substrate 210. In one example, the thermal barrier (e.g., thermal barrier 126 in Figure 1) includes housing cutout 224 made in housing 208. In another example, the thermal barrier (e.g., thermal barrier 126 in Figure 1) includes optical substrate cavity 222 and housing cutout 224.

In one example, optical substrate cavity 222, housing cutout 224, or both are filled with a material with low thermal conductivity. In another example, optical substrate cavity 222, housing cutout 224, or both are sealed vacuum cavities.

**Figure 2D-E** are block diagrams of examples of alternative geometric shapes of thermal barriers 278 and 288 integrated in substrates 276 and 286 of a semiconductor photonic package. Top view 270 shows a semiconductor photonic package with first and second photonic modules 272 and 274 mounted on the substrate 276. In one example, thermal barrier 278 carves out the substrate 276 on the side and leaves a bridge connecting substrate 276 under first and second photonic modules 272 and 274.

In another example, top view 280 shows thermal barrier 288 of a semiconductor photonic package. Thermal barrier 288 is integrated in substrate 286 between first and second photonic modules 282 and 284. In one example, thermal barrier 288 include one or more rectangular or cubic shape. In another example, thermal barrier 288 includes one or more circular or cylindrical shape holes.

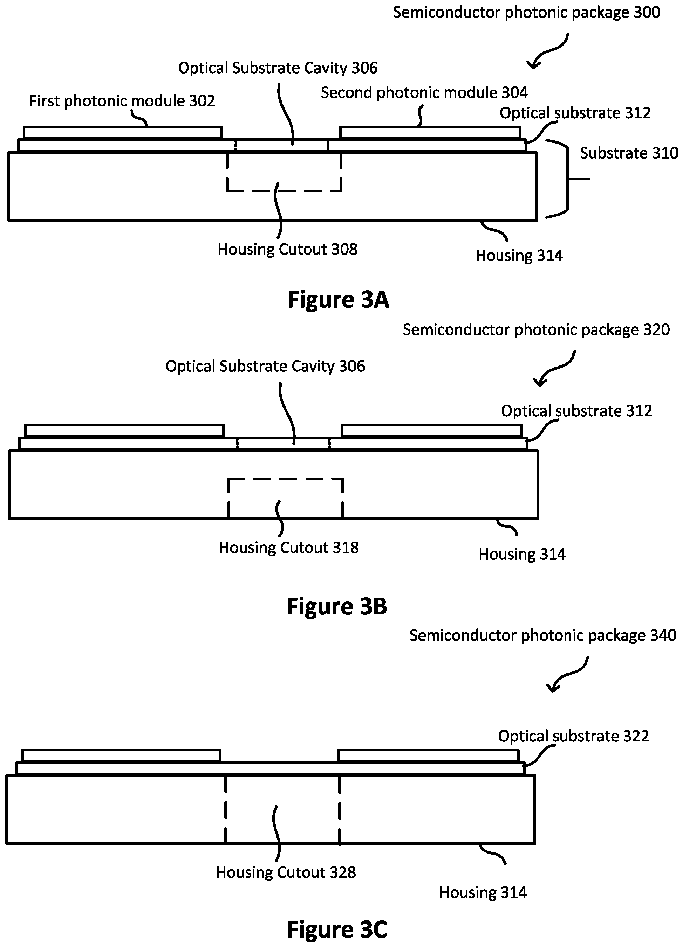

**Figure 3A-C** are block diagrams of examples of thermal barriers integrated in substrates of semiconductor photonic packages.

In one example, semiconductor photonic package 300 of **Figure 3A** includes first and second photonic modules 302 and 304 mounted on the optical substrate 312. Substrate 310 includes optical substrate 312 that is mounted on housing 314. In one example, housing cutout 308 carves out housing 314 surface under optical substrate cavity 306. In one example, the thermal barrier includes optical substrate cavity 306 and housing cutout 308. In one example, housing cutout 308 extends from the top surface toward the bottom surface of housing 314 but does not reach the bottom surface.

In another example, semiconductor photonic package 320 of **Figure 3B** includes housing cutout 318. The housing cutout 318 provides the thermal barrier. The cutout in the housing substrate can disrupt the thermal crosstalk even without a cutout in the optical substrate 312. In one example, housing cutout 318 carves out housing 314 surface opposite to the surface on which optical substrate 312 is mounted. In one example, the thermal barrier includes optical substrate cavity 306 and housing cutout 308.

In another example, semiconductor photonic package 340 of **Figure 3C** includes housing cutout 328. Housing cutout 328 provides the thermal barrier. In one example, the thermal barrier is not integrated in optical substrate 322. The cutout in the housing substrate can disrupt the thermal crosstalk even without a cutout in optical substrate 322.

In one example, housing cutout 328 is a cavity or a hole that extends from the top surface to the bottom surface (for example, top surface 262 and bottom surface 266 in Figure 2C) of housing 314. In another example, the housing cutout 328 can extend from the bottom surface toward the top surface of housing 314 but does not reach the top surface. In another example, the housing cutout 328 can extend from the top surface toward the bottom surface of housing 314 but does not reach the bottom surface. In another example, housing cutout 328 provides the thermal barrier. In another example, the cutout in the housing substrate can disrupt the thermal crosstalk even without a cutout in optical substrate 322.

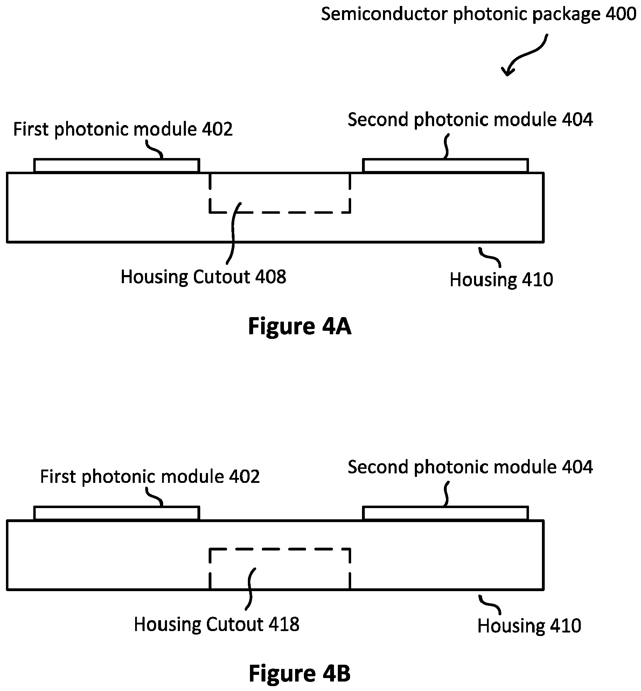

**Figure 4A-B** are block diagrams of examples of thermal barriers integrated in a housing of a semiconductor photonic package. The substrate on which photonic modules 402 and 404 are mounted in semiconductor photonic package 400 includes housing 410 and does not include a separate optical substrate. Thus, the photonic modules are mounted directly to the housing substrate represented by housing 410. In one example, the thermal barrier is made by creating housing cutout 408 or 418, made in housing 410.

In one example, illustrated in **Figure 4A**, housing cutout 408 is made on the same surface (for example, top surface 262 in Figure 2C) on which photonic modules 402 and 404 are mounted. In another example, illustrated in **Figure 4B**, housing cutout 418 is made on the opposite surface (for example, bottom surface 264 in Figure 2C) on which photonic modules 402 and 404 are mounted. In one example, housing cutout 418 cuts through housing 410 (for example, from top surface to bottom surface 262 and 264 in Figure 2C).

In one example, housing cutouts 408 or 418 are filled with materials with low thermal conductivity. In another example, housing cutouts 408 or 418 are filled with vacuum cavities, where vacuum cavities are containers with a vacuum inside.

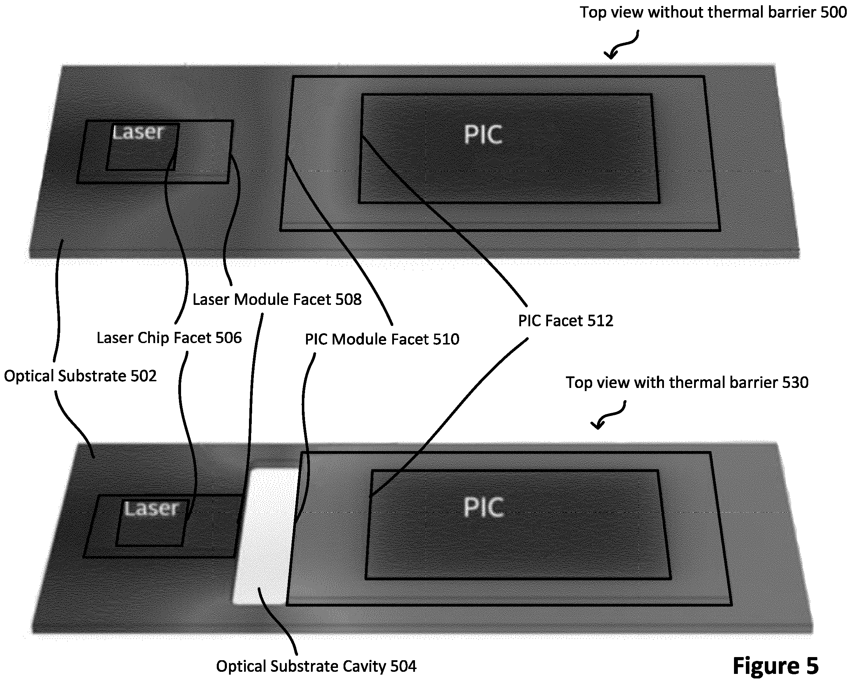

**Figure 5** illustrates a simulated thermal map of top views 500 and 530 of optical substrate 502 with and without a thermal barrier. View 500 is the top view of optical substrate 502 without a thermal barrier. Laser chip facet 506 illustrates the boundaries of the laser chip. Laser module facet 508 shows the edges of the first photonic module. Similarly, PIC facet 512 shows the boundaries of the photonic IC, and PIC module facet 510 shows the boundaries of the PIC module. The PIC module is the second photonic module. The photonic IC operates at a higher temperature than the laser chip. In one example, the difference in operating temperature is more than 10°C. Namely, the PIC module has an operating temperature of 10^{~}20°C (deg C, celsius) higher than the laser module. In one example, a thermo-electric cooler (TEC) can control the temperature of the laser chip and the photonic IC.

In one example, the thermal crosstalk can increase the operating temperature of the laser module by up to 20% of its nominal operating temperature when no thermal barrier is integrated in optical substrate 502. In one example, the photonic IC module temperature is reduced by 5% of its nominal operating temperature.

View 530 illustrates the top view of optical substrate 502 with optical substrate cavity 504. Integrating the optical substrate cavity 504, the thermal crosstalk is significantly less at the laser chip facet 506 than optical substrate 502 without a thermal barrier as in view 500. In one example, laser chip facet 506 temperature increases by only approximately 5% of its required operating temperature, and the temperature at the photonic IC facet 512 increases by less than 2%.

In view 500 and view 530, the difference in shading of the different components shows differences in temperature. For example, in view 500, the laser module has differences in shading from laser chip facet 506 to laser module facet 508, representing the fact that the laser module is being heated up. In view 530, the laser module has more even shading, representing the fact that the temperature across the module is more uniform than in view 500.

Similarly, the region between PIC facet 512 and PIC module facet 510 in view 500 has a shading gradient to represent the temperature change in the PIC module. View 530 has shading that is more even, representing the lack of temperature gradient in the PIC module. Thus, optical substrate cavity 504 is effective at disrupting thermal crosstalk between the optical modules.

The thermal barrier allows having two different temperature zones in the substrate while having only one substrate. The thermal barrier allows minimizing the crosstalk between two temperature zones in the substrate. Using a common substrate increased the optical assembly yield and optical coupling efficiency.

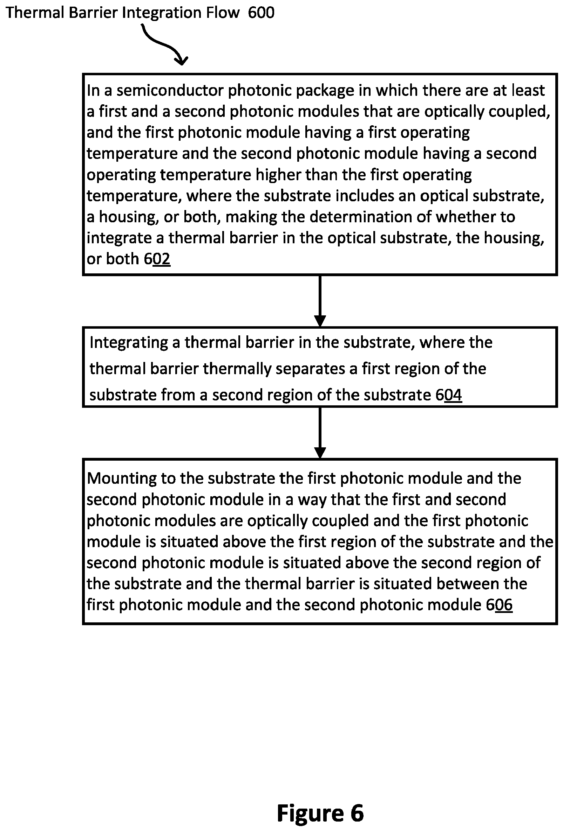

**Figure 6** is a flow diagram of a thermal barrier integration flow 600. In one example, the flow applies to a semiconductor photonic package with at least two photonic modules that are optically coupled, and at least one has an operating temperature that is different from the operating temperature of the other photonic module. The flow 600 integrates a thermal barrier in the substrate of the semiconductor photonic package that allows the photonic modules to operate with high optical coupling and stable operating temperature.

In one example, in block 602, a determination is made (as part of the design of the semiconductor package) to integrate the thermal barrier in the optical substrate. In another example, a decision is made to integrate the thermal barrier in the housing. In yet another example, a determination is made to integrate the thermal barrier in the optical substrate and housing. In one example, the criteria for integrating the thermal barrier in the optical substrate or housing includes the material used in making the semiconductor photonic package and the application for which the semiconductor photonic package is used.

In one example, in block 604, the thermal barrier is integrated in the substrate. By integrating the thermal barrier in the substrate, at least two substrate regions are thermally separated from one another.

In one example, in block 606, a first photonic module is mounted on the substrate so that the first photonic module is above a first substrate region that is thermally separate from other substrate regions. A second photonic module is mounted on the substrate so that the second photonic module is above a second substrate region that is thermally separated from the first substrate region by the thermal barrier. In one example, the first and second photonic modules are optically coupled. In one example, the thermal barrier is integrated in the substrate between the locations where the first and second photonic modules are mounted.

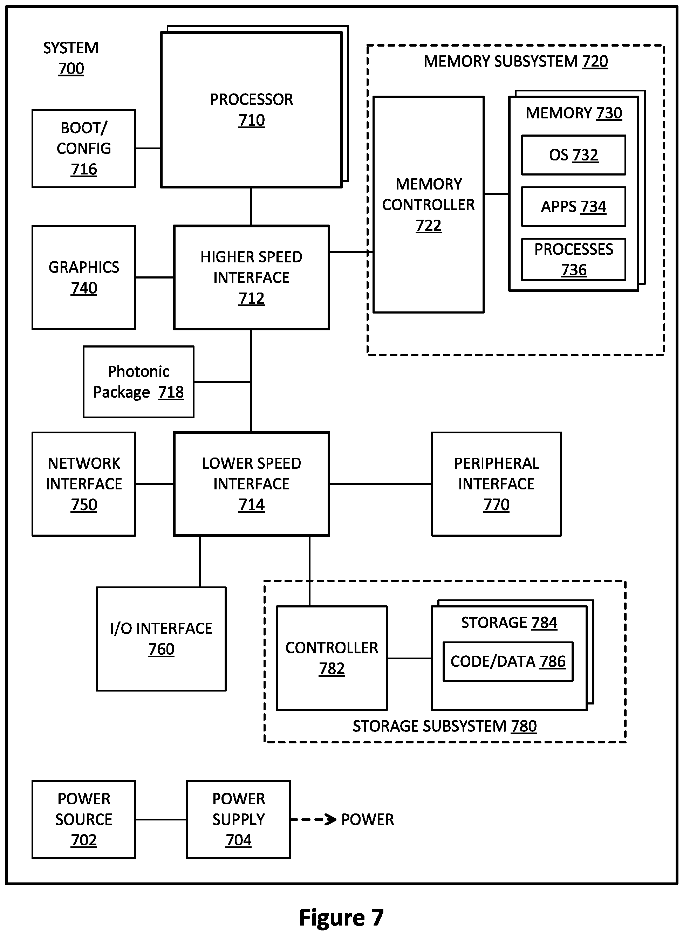

**Figure 7** is a block diagram of an example of a computing system that can include a photonic chip with an integrated thermal barrier. System 700 represents a computing device in accordance with any example herein and can be a laptop computer, a desktop computer, a tablet computer, a server, a gaming or entertainment control system, an embedded computing device, or other electronic devices.

In one example, system 700 includes photonic package 718 to perform procedures on optical signals. In one example, photonic package 718 includes two optical modules with different operating temperatures mounted on a common substrate with an integrated thermal barrier to reduce thermal cross talk, in accordance with any example herein.

System 700 includes processor 710 can include any type of microprocessor, central processing unit (CPU), graphics processing unit (GPU), processing core, or other processing hardware, or a combination, to provide processing or execution of instructions for system 700. Processor 710 can be a host processor device. Processor 710 controls the overall operation of system 700 and can be or include one or more programmable general-purpose or special-purpose microprocessors, digital signal processors (DSPs), programmable controllers, application-specific integrated circuits (ASICs), programmable logic devices (PLDs), or a combination of such devices.

System 700 includes boot/config 716, which represents storage to store boot code (e.g., basic input/output system (BIOS)), configuration settings, security hardware (e.g., trusted platform module (TPM)), or other system-level hardware that operates outside of a host OS (operating system). Boot/config 716 can include a nonvolatile storage device, such as read-only memory (ROM), flash memory, or other memory devices.

In one example, system 700 includes interface 712 coupled to processor 710, which can represent a higher speed interface or a high throughput interface for system components that need higher bandwidth connections, such as memory subsystem 720 or graphics interface components 740. Interface 712 represents an interface circuit, which can be a standalone component or integrated onto a processor die. Interface 712 can be integrated as a circuit onto the processor die or integrated as a component on a system on a chip. Where present, graphics interface 740 interfaces to graphics components for providing a visual display to a user of system 700. Graphics interface 740 can be a standalone component or integrated onto the processor die or system on a chip. In one example, graphics interface 740 can drive a high definition (HD) display or ultra high definition (UHD) display that provides an output to a user. In one example, the display can include a touchscreen display. In one example, graphics interface 740 generates a display based on data stored in memory 730 or based on operations executed by processor 710 or both.

Memory subsystem 720 represents the main memory of system 700 and provides storage for code to be executed by processor 710 or data values to be used in executing a routine. Memory subsystem 720 can include one or more varieties of random-access memory (RAM) such as DRAM, 3DXP (three-dimensional crosspoint), or other memory devices, or a combination of such devices. Memory 730 stores and hosts, among other things, operating system (OS) 732 to provide a software platform for executing instructions in system 700. Additionally, applications 734 can execute on the software platform of OS 732 from memory 730. Applications 734 represent programs with their own operational logic to execute one or more functions. Processes 736 represent agents or routines that provide auxiliary functions to OS 732 or one or more applications 734 or a combination. OS 732, applications 734, and processes 736 provide software logic to provide functions for system 700. In one example, memory subsystem 720 includes memory controller 722, which is a memory controller to generate and issue commands to memory 730. It will be understood that memory controller 722 could be a physical part of processor 710 or a physical part of interface 712. For example, memory controller 722 can be an integrated memory controller, integrated onto a circuit with processor 710, such as integrated onto the processor die or a system on a chip.

While not explicitly illustrated, it will be understood that system 700 can include one or more buses or bus systems between devices, such as a memory bus, a graphics bus, interface buses, or others. Buses or other signal lines can communicatively or electrically couple components together, or both communicatively and electrically couple the components. Buses can include physical communication lines, point-to-point connections, bridges, adapters, controllers, or other circuitry or a combination. Buses can include, for example, one or more of a system bus, a Peripheral Component Interconnect (PCI) bus, a HyperTransport or industry standard architecture (ISA) bus, a small computer system interface (SCSI) bus, a universal serial bus (USB), or other buses, or a combination.

In one example, system 700 includes interface 714, which can be coupled to interface 712. Interface 714 can be a lower speed interface than interface 712. In one example, interface 714 represents an interface circuit, which can include standalone components and integrated circuitry. In one example, multiple user interface components, peripheral components, or both are coupled to interface 714. Network interface 750 provides system 700 the ability to communicate with remote devices (e.g., servers or other computing devices) over one or more networks. Network interface 750 can include an Ethernet adapter, wireless interconnection components, cellular network interconnection components, USB (universal serial bus), or other wired or wireless standards-based or proprietary interfaces. Network interface 750 can exchange data with a remote device, which can include sending data stored in memory or receiving data to be stored in memory.

In one example, system 700 includes one or more input/output (I/O) interface(s) 760. I/O interface 760 can include one or more interface components through which a user interacts with system 700 (e.g., audio, alphanumeric, tactile/touch, or other interfacings). Peripheral interface 770 can include any hardware interface not specifically mentioned above. Peripherals refer generally to devices that connect dependently to system 700. A dependent connection is one where system 700 provides the software platform or hardware platform or both on which operation executes and with which a user interacts.

In one example, system 700 includes storage subsystem 780 to store data in a nonvolatile manner. In one example, in certain system implementations, at least certain components of storage 780 can overlap with components of memory subsystem 720. Storage subsystem 780 includes storage device(s) 784, which can be or include any conventional medium for storing large amounts of data in a nonvolatile manner, such as one or more magnetic, solid state, NAND, 3DXP, or optical based disks, or a combination. Storage 784 holds code or instructions and data 786 in a persistent state (i.e., the value is retained despite interruption of power to system 700). Storage 784 can be generically considered to be a "memory," although memory 730 is typically the executing or operating memory to provide instructions to processor 710. Whereas storage 784 is nonvolatile, memory 730 can include volatile memory (i.e., the value or state of the data is indeterminate if power is interrupted to system 700). In one example, storage subsystem 780 includes controller 782 to interface with storage 784. In one example, controller 782 is a physical part of interface 714 or processor 710 or can include circuits or logic in both processor 710 and interface 714.

Power source 702 provides power to the components of system 700. More specifically, power source 702 typically interfaces to one or multiple power supplies 704 in system 700 to provide power to the components of system 700. In one example, power supply 704 includes an AC to DC (alternating current to direct current) adapter to plug into a wall outlet. Such AC power can be renewable energy (e.g., solar power) power source 702. In one example, power source 702 includes a DC power source, such as an external AC to DC converter. In one example, power source 702 or power supply 704 includes wireless charging hardware to charge via proximity to a charging field. In one example, power source 702 can include an internal battery or fuel cell source.

In Example 1, a semiconductor photonic package includes: a first photonic module, a second photonic module, a substrate on which the first photonic module and the second photonic module are mounted, and a thermal barrier integrated in the substrate between the first photonic module and the second photonic module to thermally separate a first region of the substrate under the first photonic module from a second region of the substrate under the second photonic module.

In Example 2, the semiconductor photonic package of example 1, wherein the thermal barrier comprises a material with low thermal conductivity.

In Example 3, the semiconductor photonic package of any preceding example, wherein the substrate comprises an optical substrate and further comprising a housing, wherein the first module and the second module to mount to the optical substrate, and the optical substrate to mount to the housing.

In Example 4, the semiconductor photonic package of any preceding example, wherein the optical substrate is aluminum nitride (AIN).

In Example 5, the semiconductor photonic package of any preceding example, wherein the thermal barrier comprises at least one cutout in the housing.

In Example 6, the semiconductor photonic package of any preceding example, wherein the thermal barrier comprises at least one cavity in the optical substrate.

In Example 7, the semiconductor photonic package of any preceding example, wherein the thermal barrier comprises at least one cavity in the optical substrate and at least one cutout in the housing.

In Example 8, the semiconductor photonic package of any preceding example, wherein the substrate comprises a housing.

In Example 9, the semiconductor photonic package of any preceding example, wherein the thermal barrier comprises a cutout in the housing.

In Example 10, a computer system comprising: a processor; and a semiconductor photonic package comprising: a first photonic module; a second photonic module; a substrate on which the first photonic module and the second photonic module are mounted; and a thermal barrier integrated in the substrate between the first photonic module and the second photonic module to thermally separate a first region of the substrate under the first photonic module from a second region of the substrate under the second photonic module.

In Example 11, the computer system of example 10, wherein the thermal barrier comprises a material with low thermal conductivity.

In Example 12, the computer system any preceding example, wherein the substrate comprises an optical substrate and further comprising a housing, wherein the first module and the second module to mount to the optical substrate; and the optical substrate to mount to the housing.

In Example 13, the computer system of any preceding example, wherein the optical substrate is aluminum nitride (AIN).

In Example 14, the computer system of any preceding example, wherein the thermal barrier comprises at least one cutout in the housing.

In Example 15, the computer system of any preceding example, wherein the thermal barrier comprises at least one cavity in the optical substrate.

In Example 16, the computer system of any preceding example, wherein the thermal barrier comprises at least one cavity in the optical substrate and at least one cutout in the housing.

In Example 17, the computer system of any preceding example, wherein the substrate comprises a housing and the thermal barrier comprises a cutout in the housing.

In Example 18, a semiconductor photonic package includes: a substrate including: a housing and an optical substrate, the optical substrate mounted on the housing; and a thermal barrier integrated in the substrate including: at least one cavity through the optical substrate; and at least one cutout in the housing; a first photonic module including a laser chip, a first lens, and an isolator, the first photonic module mounted on the optical substrate to a first side of the thermal barrier; and a second photonic module including a second lens and a photonic integrated circuit, the second photonic module mounted on the optical substrate to a second side of the thermal barrier, the second side across the thermal barrier from the first side.

In Example 19, the semiconductor photonic package of example 18, wherein the at least one cutout in the housing extends through the housing from a first face of the housing on which the optical substrate is mounted, to a second face of the housing opposite of the first face of the housing.

In Example 20, the semiconductor photonic package of any preceding example, wherein the at least one cavity through the optical substrate comprises one of at least two cavities through the optical substrate; and the at least one cutout in the housing comprises one of at least two cutouts in the housing.

Flow diagrams, as illustrated herein, provide examples of sequences of various process actions. The flow diagrams can indicate operations to be executed by a software or firmware routine, as well as physical operations. A flow diagram can illustrate an example of the implementation of states of a finite state machine (FSM), which can be implemented in hardware and/or software. Although shown in a particular sequence or order, the order of the actions can be modified unless otherwise specified. Thus, the illustrated diagrams should be understood only as examples, and the process can be performed in a different order, and some actions can be performed in parallel. Additionally, one or more actions can be omitted; thus, not all implementations will perform all actions.

To the extent various operations or functions are described herein, they can be described or defined as software code, instructions, configuration, and/or data. The content can be directly executable ("object" or "executable" form), source code, or difference code ("delta" or "patch" code). The software content of what is described herein can be provided via an article of manufacture with the content stored thereon or via a method of operating a communication interface to send data via the communication interface. A machine-readable storage medium can cause a machine to perform the functions or operations described and includes any mechanism that stores information in a form accessible by a machine (e.g., computing device, electronic system, etc.), such as recordable/non-recordable media (e.g., read-only memory (ROM), random access memory (RAM), magnetic disk storage media, optical storage media, flash memory devices, etc.). A communication interface includes any mechanism that interfaces to any of a hardwired, wireless, optical, etc., medium to communicate to another device, such as a memory bus interface, a processor bus interface, an Internet connection, a disk controller, etc. The communication interface can be configured by providing configuration parameters and/or sending signals to prepare the communication interface to provide a data signal describing the software content. The communication interface can be accessed via one or more commands or signals sent to the communication interface.

Various components described herein can be a means for performing the operations or functions described. Each component described herein includes software, hardware, or a combination of these. The components can be implemented as software modules, hardware modules, special-purpose hardware (e.g., application-specific hardware, application-specific integrated circuits (ASICs), digital signal processors (DSPs), etc.), embedded controllers, hardwired circuitry, etc.

Besides what is described herein, various modifications can be made to what is disclosed and implementations of the invention without departing from their scope. Therefore, the illustrations and examples herein should be construed in an illustrative and not a restrictive sense. The scope of the invention should be measured solely by reference to the claims that follow.

## Claims

1. A semiconductor photonic package comprising:
a first photonic module;
a second photonic module;
a substrate on which the first photonic module and the second photonic module are mounted; and
a thermal barrier integrated in the substrate between the first photonic module and the second photonic module to thermally separate a first region of the substrate under the first photonic module from a second region of the substrate under the second photonic module.

2. The semiconductor photonic package of claim 1, wherein the thermal barrier comprises a material with low thermal conductivity.

3. The semiconductor photonic package of claim 1 or 2, wherein the substrate comprises an optical substrate and further comprising a housing, wherein
the first module and the second module to mount to the optical substrate; and
the optical substrate to mount to the housing.

4. The semiconductor photonic package of claim 3, wherein the optical substrate is aluminum nitride (AIN).

5. The semiconductor photonic package of claim 3 or 4, wherein the thermal barrier comprises at least one cutout in the housing.

6. The semiconductor photonic package of any of claims 3-5, wherein the thermal barrier comprises at least one cavity in the optical substrate.

7. The semiconductor photonic package of any of claims 3-6, wherein the thermal barrier comprises at least one cavity in the optical substrate and at least one cutout in the housing.

8. The semiconductor photonic package of claim 1 or 2, wherein the substrate comprises a housing.

9. The semiconductor photonic package of any of claims 3-8, wherein the thermal barrier comprises a cutout in the housing.

10. The semiconductor photonic package of any of claims 1-9, wherein:
the first photonic module including a laser chip, a first lens, and an isolator; and
the second photonic module including a second lens and a photonic integrated circuit.

11. A computer system comprising:
a processor; and
a semiconductor photonic package in accordance with any of claims 1-9.
